# EUROPEAN PATENT SPECIFICATION

(11) **EP 0 919 816 B1**
(45) Date of publication and mention of the grant of the patent: **27.12.2006**
(21) Application number: 98113782.1
(22) Date of filing: 23.07.1998
(51) Int. Cl.: G01R 1/04

(54) **Electrical connecting apparatus**
Elektrische Verbindungsvorrichtung
Dispositif de connexion électrique

(30) Priority: 25.11.1997 JP 33822497
(43) Date of publication of application: 02.06.1999
(73) Proprietor: Kabushiki Kaisha Nihon Micronics, Musashino-shi-shi, Tokyo (JP)
(72) Inventor: Hasegawa, Yoshiei, Kawasaki-shi, Kanagawa-ken 215 (JP); Osato, Eichi, Minamitsugaru-gun, Aomori-ken, 036-02 (JP)
(74) Representative: Turi, Michael

(56) References cited:
- EP-A- 0 407 131
- EP-A- 0 552 910
- US-A- 5 336 094
- US-A- 5 388 996
- US-A- 5 461 258
- US-A- 5 743 749

## Description

### FIELD OF THE INVENTION

The present invention relates to a connecting apparatus for use in testing a plate-like device to be inspected such as an integrated circuit and a liquid crystal panel.

### BACKGROUND OF THE INVENTION

Generally, an inspection or a test of electrical characteristic of a packaged or molded semiconductor device, more particularly, an integrated circuit (IC) is performed by utilizing an electrical connecting apparatus such as a test socket, i.e.,an inspection socket as an auxiliary apparatus to which a semiconductor device is removably attached.

There is provided a connecting apparatus of such a type using a crank-shaped contact, i.e., a probe wherein a needle front portion to be in contact with a lead (electrode portion) of a semiconductor device and a needle tail portion to be connected to a conductive portion of a base plate is bent in the opposite directions (Japanese Patent Appln. Public Disclosure No. 7-229949).

In this conventional connecting apparatus, each probe is attached to a common needle presser by an adhesive in the intermediate portion between the needle front portion and the needle tail portion such that the needle front portion extends upward and the needle tail portion extends downward.

In this conventional connecting apparatus, however, an assembling work such as attaching a probe to the needle presser or soldering the needle tail portion to the conductive portion of the base plate requires skill, and since the length dimension of an effective area (from the tip end of the probe to a connecting point to the conductive portion) is great, there is a limitation in raising the frequency of an electric signal used for testing.

There is another connecting apparatus using a plate-like probe formed in a Z-like shape or an annular shape (US Patent No. 5,336,094 and US Patent No. 5,388,996). In this conventional connecting apparatus, however, each probe is pressed against an electrode portion of a device to be inspected in its arc-shaped deformed face portion, so that only a wiping effect and no scraping action due to a displacement of the deformed face portion relative to the electrode portion occurs, so that a film like an oxide film existing in the electrode portion is not effectively eliminated. Consequently, a favorable electric contact between the probe and the electrode portion cannot be obtained.

Another connecting apparatus uses probes comprising a plate-like elastic supporting element and a front portion having an elliptic cross section (EP 0 407 131 A2). The front portion is adapted to be bent when a terminal of an electric part of, e.g. an IC, is pressed via a presser on the front portion. Additionally, the plate-like elastic supporting element can be bent also. However, no wiping effect occurs during bending of the front portion.

A similar probe used by a connecting apparatus is disclosed in JP-9-232481. The disclosed probe comprises an elastic supporting member and a front portion including a pivotable contact having an elliptic cross section. When pressing a terminal of a device to be tested on the contact of the probe, the contact will execute a pivoting movement leading to a slidable contact between the terminal and the contact, and thus to a wiping action.

There is an auxiliary apparatus for testing the electrical characteristic of a non-packaged or non-molded semiconductor device, particularly an IC chip, which uses a probe bent in a C-like shape (Japanese Patent Appln. Public Disclosure No. 5-299483). According to this conventional auxiliary apparatus, however, since each probe is only held in a socket by its own spring force, the probe is unstable, and since both ends of the C-like shape must be further curved, the probe becomes complicated in shape and expensive.

Accordingly, in a connecting apparatus, it is important to simplify the shape of a probe, to enhance the stability of the probe, to make it adapted to a high frequency test, and to facilitate manufacturing same, though it gives an effective scarping action to the electrode portion of the device to be inspected.

### SUMMARY OF THE INVENTION

The connecting apparatus relative to the present invention as defined in the appended claims is for electrically connecting a plurality of electrode portions of a device to be tested and a plurality of conductive portions formed on one face of a base plate, when the device to be tested is pushed toward the base plate by a presser, comprises a plurality of probes, and assembling equipment for assembling the probes in parallel into the base plate. Each probe includes a deformed portion, a needle portion and having a tip end or needle tip to be pressed against an electrode portion of a plate-like device to be inspected, and a needle tail portion following the other end of the deformed portion. The assembling equipment has a needle pressing portion for pressing the probes so as to bring at least a part of the deformed portions of the probes into contact with the conductive portions of the base plate and extending in the arranging direction of the probes.

Though having the deformed portion, the probe is simple in shape in comparison with the conventional C-shaped probe and less expensive. The probes are pressed against the conductive portions of the base plate at least at a part of the deformed portion or the needle tail portion by the needle pressing portion and sandwiched between the base plate and the needle pressing portion to be maintained in that state, so that the probe are stabilized to facilitate assembling of the auxiliary apparatus.

Each probe, similarly to the conventional crank-shaped probe, is pressed at the needle tip against the electrode portion of the device to be inspected. Thereby, each probe is elastically deformed at a portion between the portion in contact with the conductive portions and a portion at the side of the tip end, and the needle tip is displaced relative to the electrode portion. As a result, a part of the film like an oxide film existing in the electrode portion is scraped off ( or scratched away) by the needle tip, and the probe and the electrode portion are maintained in a favorable electrically connected state. Also, from the portion in contact with the conductive portion to the needle tip becomes an effective area, so that the probe has a smaller effective area than the conventional probe, to reduce a leakage of the electric signal between adjacent probes and to make the probe suitable for a high frequency test.

As mentioned above, according to the present invention, a favorable state of electrical connection is maintained between the probe and the electrode portion by an effective scraping action caused between the needle tip and the electrode portion. Also, in comparison with a C-shaped one, the probe is simple in shape and costs less. Further, the effective area of the probe becomes smaller and suitable for a high frequency test. Still further, the probe is maintained stable, thereby facilitating the manufacture of the auxiliary apparatus.

The assembling equipment can include one or more covers assembled into the base plate and one or more needle pressers received in a recess so as to extend in the arranging direction of the probes, the recess can be opened at least at the side of the base plate and the needle pressing portion can be formed in the needle presser. Thus, since each probe can be maintained by disposing the deformed portion of each probe in a groove, the manufacture of the auxiliary apparatus is facilitated, though the probes can be maintained in a more stable state.

Further, the cover may have a plurality of grooves at intervals in the arranging direction of the probes, these grooves may be opened toward both sides of the base plate and the opening, the recess may be opened toward the grooves, and at least the deformed portions of the probes may be disposed in the grooves.

The needle presser portion can be made to abut against the inside portion of at least the deformed portion of the probe by projecting it from the recess of the cover to the side of the base plate. Also, the sectional shape of the recess of the cover can be made arc-shaped or rectangular.

The needle presser can be made cylindrical, and at least the outer peripheral portion of the needle presser can be electrically insulated. Thus, the structure of the needle presser is simplified, and an electrical short-circuit between the probes by the needle presser can be prevented.

The needle presser can include a presser bar and an elastic material layer formed of an insulated material around the presser bar. Thus, not only an electrical short-circuit between the probes by the needle presser can be prevented but also the probes are pressed against the base plate through the elastic material, so that the probes can be maintained in a more stable state.

The needle tail portion of the probe can be pressed against the inner face of the recess by the needle presser. Thereby, the relative displacements in the longitudinal direction of the probe between the needle presser and the probe can be surely hindered, so that the probes can be maintained in a more stable state.

The probe may be formed to have a generally curved arc-like shape or a generally curved U- or J-like shape. Also, the needle front portion of each probe can be projected through the opening of the cover.

Each probe can be formed of a conductive material with a non-conductive material layer formed in the outer periphery of the needle tail portion. Thereby, an electrical short-circuit in the needle tail portions of adjacent probes can be prevented.

However, each probe may be formed of a non-conductive material with a conductive material layer formed in the outer peripheries of the needle front portion and the deformed portion, or the entire needle tail portion of each probe may be formed of a non-conductive material with the needle tail portions formed of two or more probes integrally of a non-conductive material.

Since in none of the above-mentioned probes the needle tail portion has conductivity, not only an electrical short-circuit in the needle tail portions of adjacent probes can be prevented but also the length dimension of the conductive portion is shortened. As a result, there is no leakage of an electric signal in the needle tail portion, and besides, a leakage of an electric signal between adjacent probes occurs less than the conventional apparatus, so that the frequency of an electric signal used for a high frequency test can be enhanced.

It is, however, possible to form the entire needle tail portion of each probe of a non-conductive material and to form the needle tail portions of two or more probes integrally of a non-conductive material.

The needle tail portions of two or more probes can be integrated with a non-conductive material and received in the recess. Thereby, it is enabled to manufacture the needle assembly composed of the deformed portions of two or more probes, the needle front portions and the integrated needle tail portions at one time by fabrication from a synthetic resin and to assemble them on the base plate at one time, facilitating the manufacture of the needle assembly and also facilitating the assembling work of the apparatus and, consequently, the manufacturing work of the apparatus.

The assembling equipment can further include a retraction preventive portion for preventing the probe from retracting and have the tail end portion of the probe connected with the retraction preventive portion. Thereby, even if the probe is subjected to an overdrive action, the probe would not retract but the probe itself would be surely elastically deformed, or the needle tail portion deforms the needle presser under compression. As a result, the needle tip of the probe surely and effectively gives a scraping action to the electrode portion, thereby to maintain the probe and the electrode portion in a favorable state of electrical connection.

The probe can include an outside region extending in an arc-like shape and to be brought into contact with the conductive portion when at least the electrode portion is pressed by the needle tip. Thereby, the greater becomes the pressing force by the device to be inspected, the contact portion of the outside region with the conductive portion changes toward the side of the needle tip.

The assembling equipment may include one or more covers and one or more needle pressers having a needle presser portion, the cover being assembled into the base plate and having a recess extending in the arranging direction of the probes as well as the retraction preventive portion, and opening at the side of the base plate. Thereby, since the needle presser does not displace relative to the cover, the probe becomes more stable, and an assembling work becomes easier.

The cover is further provided with a plurality of slots at intervals in the longitudinal direction of the needle presser, opening at the sides of the base plate and the device to be inspected and communicating with the recess, so that the needle front portion of each probe is passed through the slot to project the needle tip out of the slot. Thereby, since the position of the needle front portion in the arranging direction of the probes is regulated by the slot, the probe becomes more stable, and the assembling work becomes easier.

Instead of this, the cover may have a plurality of the slots opening at the side of the base plate and communicating with the recess and placed at intervals in the longitudinal direction of the needle presser. Part of the deformed portion of each probe can be disposed in the slot. Also by this, since the positions of the probes in the arranging direction of the probes are regulated by the slots, the probe becomes more stable, and the assembling work becomes easier.

The retraction preventive portion can include the inner face of the recess or the end face of the slot. In this case, the probe can include the rear end face in contact with the retraction preventive portion. However, the stopper disposed in the cover to form the retraction preventive portion may be provided in the assembling equipment.

In a preferred embodiment, the probe is curved in an arc-like shape at least at the deformed portion.

The accompanying drawings are included to provide a further understanding of the invention and are incorporated in and constitute a part of this specification, to illustrate the embodiments of the invention, and, together with the description, to explain the principles of the invention.

### BRIEF DESCRIPTION OF THE DRAWINGS

Fig. 1 is a plan view showing a first embodiment of a connecting apparatus the present invention.
Fig. 2 is a cross-sectional view taken along the line 2-2 of Fig. 1.
Fig. 3 is a bottom view of a part of the connecting apparatus shown in Fig. 1 with the base plate removed.
Fig. 4 is a cross-sectional view taken along the line 4-4 of Fig. 1.
Fig. 5 is a cross-sectional view for explaining a state of a probe when a device to be inspected is disposed in the connecting apparatus.
Fig. 6 is a cross-sectional view for explaining a state of a probe when a device to be inspected is pressed against the probe.
Fig. 7 are views showing the first embodiment of the probe used in the connecting apparatus shown in Fig. 1, in which (A) is a front elevation and (B) a left side view.
Fig. 8 are views showing a second embodiment of the probe used in the connecting apparatus shown in Fig. 1, in which (A) is a front elevation and (B) a left side view.
Fig. 9 is a cross-sectional view showing a part of the second embodiment of the connecting apparatus.
Fig. 10 is a cross-sectional view showing a part of a third embodiment of the connecting apparatus.
Fig. 11 is a view showing a part of a third embodiment of the probe used in the connecting apparatus shown in Fig. 1.
Fig. 12 is a cross-sectional view showing a part of a fourth embodiment of the connecting apparatus.
Fig. 13 is a cross-sectional view showing a part of a fifth embodiment of the connecting apparatus.
Fig. 14 are views showing an embodiment of the probe used in the connecting apparatus shown in Fig. 13, in which (A) is a plan view, (B) a front elevation, and (C) a right side view.
Fig. 15 are views showing another embodiment of the probe used in the connecting apparatus shown in Fig. 13, in which (A) is a plan view, (B) a front elevation, and (C) a right side view.
Fig. 16 is a cross-sectional view showing a part of a sixth embodiment of the connecting apparatus.
Fig. 17 are views showing an embodiment of the probe used in the connecting apparatus shown in Fig. 16, in which (A) is a plan view, (B) a front elevation, and (C) a right side view.
Fig. 18 are views showing another embodiment of the probe used in the connecting apparatus shown in Fig. 16, in which (A) is a plan view, (B) a front elevation, and (C) a right side view.
Fig. 19 is a cross-sectional view showing a part of a seventh embodiment of the connecting apparatus.
Fig. 20 is a cross-sectional view showing a part of an eighth embodiment of the connecting apparatus.
Fig. 21 is a view taken along the line 21-21 in Fig. 20.
Fig. 22 is a view taken along the line 22-22 in Fig. 20.
Fig. 23 and 24 are views showing the deformation of the connecting apparatus.

### DETAILED DESCRIPTION OF THE PREFERRED EMBODIMENTS

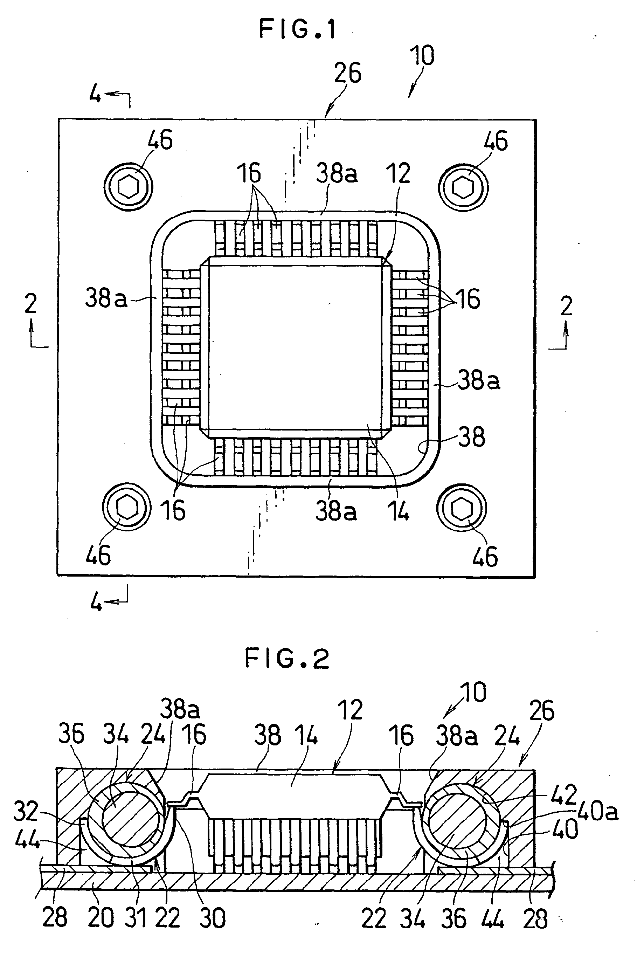

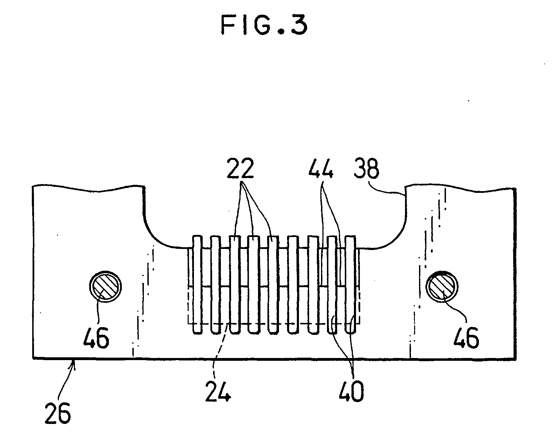

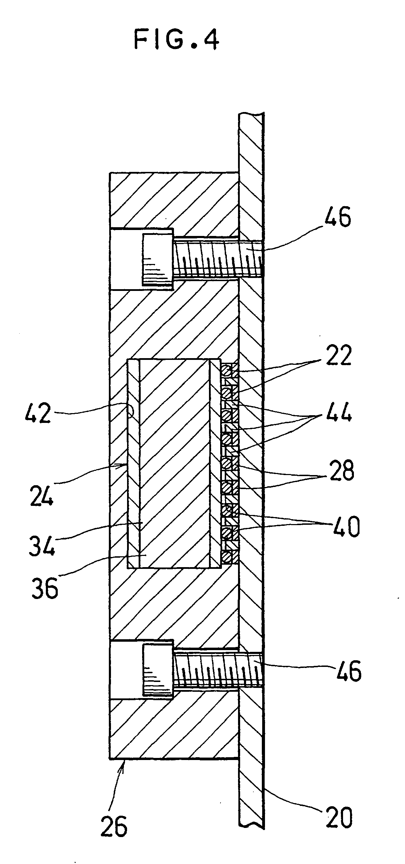

Referring to Figs. 1 to 6, a connecting apparatus 10 is used as an auxiliary apparatus for testing or inspecting a plate-like device 12 to be tested. In the illustrated embodiment, the device 12 is a semiconductor device such as a packaged or molded integrated circuit, but the present invention can also be applied to a connecting apparatus for testing another plate-like device such as a liquid crystal display panel.

The device 12 includes a base portion 14 packaged or molded in a rectangular flat shape, and a plurality of leads, i.e., electrode portions 16 projecting outward from a region corresponding to each side of the rectangle. The electrode portions 16 are divided into a plurality of electrode groups corresponding to each side of the rectangle, and the leads are juxtaposed in each electrode portion group.

The auxiliary apparatus, i.e., connecting apparatus 10 comprises a base plate 20, a plurality of contacts, i.e., probes 22, a plurality of needle pressers 24 for pressing the probes 22 against the base plate 20, and a plate-like cover 26 for assembling the needle pressers 24 into the base plate 20.

The base plate 20 is a printed wiring board with a wiring pattern formed on one surface of an insulated material by a print wiring technique, and has a plurality of belt-like printed conductive or wiring portions 28 respectively corresponding to the probes 22 on one surface. Each conductive portion 28 is a part of the wiring pattern. The conductive portions 28 are divided into a plurality of conductive portion groups corresponding to each side of the rectangle of the base portion 14 of the device 12, and the conductive portions are juxtaposed in each group.

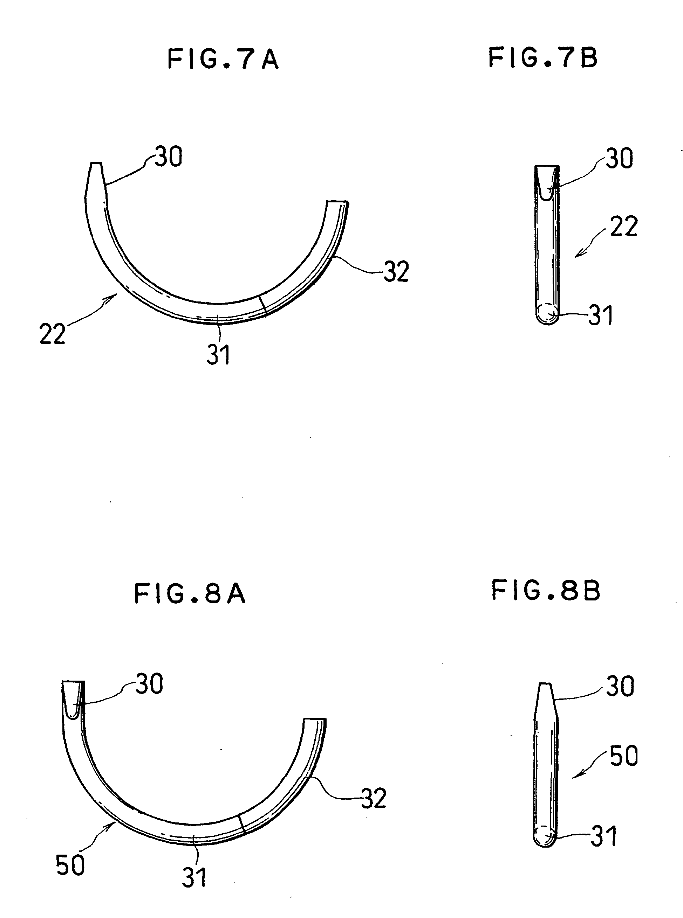

Each probe 22 is formed, as shown in Fig. 7, in a shape of elastic non-conductive fine line and is curved like a semicircular arch over the whole area from a tapered needle front portion 30 to a needle tail portion 32 through an arc-shaped needle base portion, i.e., deformed portion 31.

Each probe 22 has a conductive coat formed in portions other than the needle tail portion in the area shown by the reference numeral 32 in Figs. 7A, 7B and 7C, that is, in the entire external surfaces of the needle front portion 30 and the curved portion, i.e., deformed portion 31. Thereby, the portion ahead of the portion in contact with the conductive portion 28 has conductivity, while the needle tail portion 32 has non-conductivity. Therefore, though acting as a conductive probe, there is no leakage of an electric signal for testing in the needle tail portion 32, particularly no leakage of an electric signal between adjacent probes.

However, each probe 22 may have a core formed of a conductive fine line, preferably in a shape of a metal fine line, with a non-conductive coat formed in the needle tail portion 32 in the core. The probe 22 may be formed of a fine line of metal, ceramic, synthetic resin or the like, and by a process such as press working, etching work, etc., using such a material.

Each probe 22 has a circular sectional shape in the examples shown in Figs. 1 through 7. Further, the probe 22 is a so-called chisel-type needle with its needle tip, i.e., tip end extending at right angles to the curved face of the probe 22.

Each probe 22, however, like the probe 50 shown in Fig. 8, may be an ax-type needle with its tip end extending parallel to the curved face of the probe 22, or of a shape having a conical or pyramidal needle front portion. The sectional shape of the probe may be either circular or square.

The probes 22 are divided into a plurality of probe groups corresponding to each side of the rectangle of the base portion 14 of the device 12 to be inspected. In the illustrated embodiment, the device 12 has a plurality of electrode portions at each of the four sides of the rectangle, and the probes 22 are divided into four probe groups. For the same reason, in the illustrated embodiment, there are provided four needle pressers 24.

Each needle presser 24 is shaped to be cylindrical by a cylindrical presser bar 34 and an insulated elastic material layer 36 formed in the peripheral surface of the presser bar 34. The presser bar 34 can be a conductive or a non-conductive bar-like member. An insulated layer, i.e., the elastic material layer 36 may be a tube formed of a rubber material such as silicone rubber. The needle presser 24 may, however, be formed like a bar of a single member such as an elastically deformable rubber.

The cover 26 includes an opening 38 formed in the center so as to accommodate the device 12 to be inspected, a plurality of slots 40 formed outside the opening 38 so as to extend outwardly relative to the opening 38, and a plurality of recesses 42 formed outside the opening and extending in the arranging direction of the slots 40 continuously. Such a cover 26 can be formed of a non-conductive material.

The opening 38 has a rectangular shape analogous to the device 12 with their respective corner portions arc-shaped. The upper portion of the opening 38 is tapered downward by an inclined plane 38a directed from the outside toward the center side. Each corner portion of the opening 38 is an arc-shaped plane.

The slot 40 is a slot for accommodating at least the deformed portion 31 and the needle tail portion 32 of the probe 22. Accordingly, in the illustrated embodiment the same number of the slots as that of the probes 22 are provided. The slots 40 are divided into a plurality of slot groups corresponding to each side of the rectangle forming the opening 38, and the slots are juxtaposed in each group. Each slot 40 opens at the side of the base plate 20, that is, downward and at the opening 38.

Adjacent slots 40 are divided by partition walls 44. The partition walls 44 are provided, in the illustrated embodiment, so as to divide the rear half of the slot 40, and therefore, adjacent slots 40 are continuous at the portion of the opening 38. However, the partition walls 44 may be provided so as to divide the entire slots 40.

The recesses 42 correspond to each side of the rectangle forming the opening 38 and extend along the corresponding side. In the illustrated embodiment, four recesses 42 are provided. Each recess 42 is a semicircular groove accommodating the needle presser 24 and opens at the slot bottom surface of the corresponding slot 40. The groove bottom surface of each recess 42 is upwardly convex in cross-section.

The connecting apparatus 10 can be assembled by disposing each needle presser 24 in the recess 42, each probe 22 in the slot 40 such that its rear end is in contact with the deep bottom surface (in the illustrated embodiment, the upper surface), overlapping in that state the probe 22, the needle presser 24 and the cover 26 on the base plate 20, and attaching the cover 26 to the base plate 20 with a plurality of screw members 46 such as bolts.

Each screw member 46 penetrates the cover in its thickness direction and is screwed into a screw hole formed in the base plate 20. As a result, the probe 22 is pressed against the conductive portion 28 of the base plate 20 at a part of the arc-shaped curved portion 31 by the needle presser 24 and maintained in a state of being sandwiched between the base plate 20 and the needle presser 24.

In the illustrated embodiment, the needle presser 24, the cover 26 and the screw member 46 act as an assembling equipment for assembling the probes 22 in parallel in the base plate 20. Also, since the lower half portion of each needle presser 24 projects in an arc-like shape from the recess 42 to the side of the base plate 20 and extends in the arranging direction of the probes 22, they act as a needle presser portion in contact with the inside of the curved portion of the probe 22 so as to press the probe 22 against the base plate 20.

By disposing the probes 22 in the slots 40 such that the needle front portions 30 project upward within the opening 38 and merely bringing the probes 22 into contact with the base plate 20 with the needle pressers 24, the probes 22 can be correctly juxtaposed in each probe group. Therefore, the fabrication of the connecting apparatus 10 is easy.

Since at least the needle tail portion 32 of the probe 22 is received in a portion divided by the partition wall 44 in the state of being assembled into the connecting apparatus 10 and pressed against the base plate 20 through the elastic material layer 36 made of an insulated material, the probe 22 is maintained in a more stable state by the slot 40 and the needle presser 24 to be surely prevented from being brought into electrical contact with the adjacent probe.

In an assembled state, each probe 22 is pressed against the conductive portion 28 at an arc-shaped outside face of the deformed portion 31 where no insulated layer 32 exists, so that the region of the base portion 31 of the arc-shaped needle acts as the deformed portion.

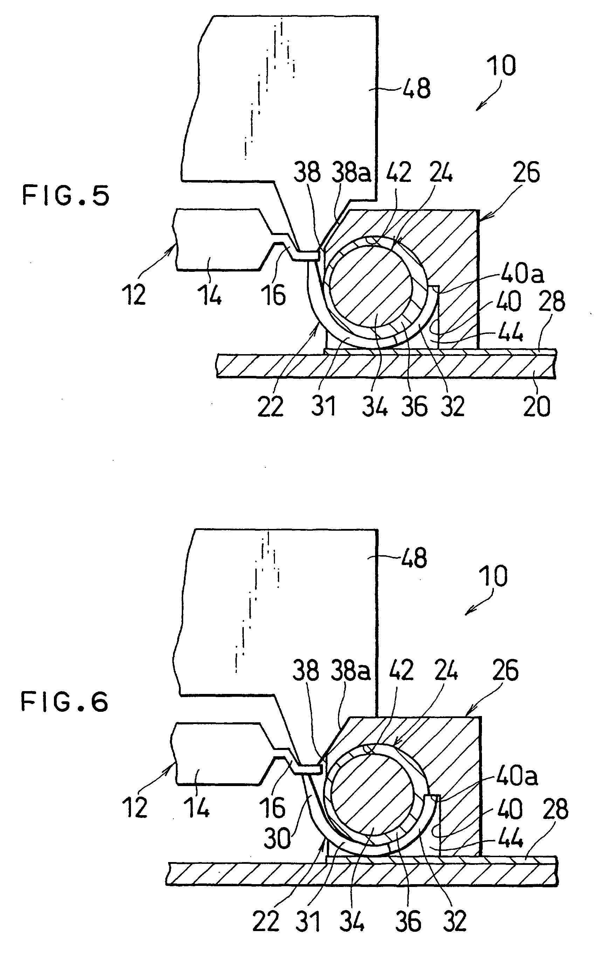

Since each probe 22 is pressed against the conductive portion 28 at a region where no insulated layer 32 exists, the effective area of the probe 22 is from the portion of the probe 22 in contact with the conductive portion 28 to the needle tip, and is smaller than the conventional connecting apparatus. Also, as shown in Fig. 5, since the elastic material layer 36 is pressed against the base plate 20, the cover 26 and the presser bar 34 to be deformed, each probe 22 is firmly maintained. The presser bar 34 and the elastic material layer 36 may be previously made eccentric to each other or may be made eccentric to each other in the assembled state.

In inspecting, the device 12 is put in the opening 38 from above. At this time, if the position of the device 12 is deviated relative to the connecting apparatus 10, the device 12 is in contact with the inclined plane 38a and is guided by the inclined surface 38a to the center of the opening 38. Thereby, the device 12 is, as shown in Fig. 5, accommodated in the connecting apparatus 10 in a state that the electrode portion 16 is in contact with the needle tip of the probe 22.

When the device 12 disposed in the connecting apparatus 10 is pressed down by a presser 48, each probe 22 is deformed under an overdrive action, as shown in Fig. 6. At this time, force to retract the probe along the arc-shaped outside face of the deformed portion 31 acts on the probe 22. The rear end of each probe 22 is, however, in direct contact with the end surface 40a of the slot 40, so that each probe 22 does not move (retract) in the circumferential direction of the needle presser 24.

However, when the probe 22 and the device 12 are pressed, each probe 22 is elastically deformed at a region from the portion in contact with the conductive portion 28 to the needle tip side so as to increase the radius of curvature without the probe 22 being retracted in the circumferential direction (curving direction of the deformed portion 31) of the needle presser 24 and so as to elastically deform the elastic material layer 36 to deform under compression.

Thereby, the needle tip of each probe 22 displaces relative to the electrode portion 16, causing a scraping action (or scratching action) to remove a part of the film existing in the surface of the electrode 16. Also, in each probe 22, a part of its tail end deforms the elastic material layer 36 to dent, thereby preventing the needle front portion 30 from falling in the axial direction of the needle presser 24.

As shown in Fig. 6, when the probe 22 is elastically deformed, the portion of the probe 22 in contact with the conductive portion 28 is changed toward the side of the needle tip. Also, since the elastic material layer 36 has been dented by the rear end of the probe, the rear end of the probe 22 tends to be apart from the inner face of the recess 40. However, the probe 22 is pushed back by restoring force of the needle presser 24 and slides slightly against the conductive portion 28.

Since this slide is a movement of the probe 22 to displace with its rear end face in contact with the inner face 40a (namely, not a movement of the probe 22 to retract along the periphery of the needle presser 24), an elastic deformation of the probe 22 so as to increase the radius of curvature is not affected by the slide such as the above. Therefore, the probe 22 is surely elastically deformed.

According to the connecting apparatus 10, as mentioned above, not only the probe is simple in shape and costs less but also the effective area of the probe 22 is small to suit a high frequency test, and though the probe is kept stable, it is easy to manufacture the connecting apparatus. Also, the device 12 is disposed in the connecting apparatus 10 in a natural and correct state, the electrode portion 16 of the device 12 is surely brought into contact with the needle tip, and besides, elastically deforming without retracting, gives a scraping action effectively to the electrode portion 16. Further, the structure of the needle presser 24 is simple, and an electric short-circuit between the probes 22 can be surely prevented.

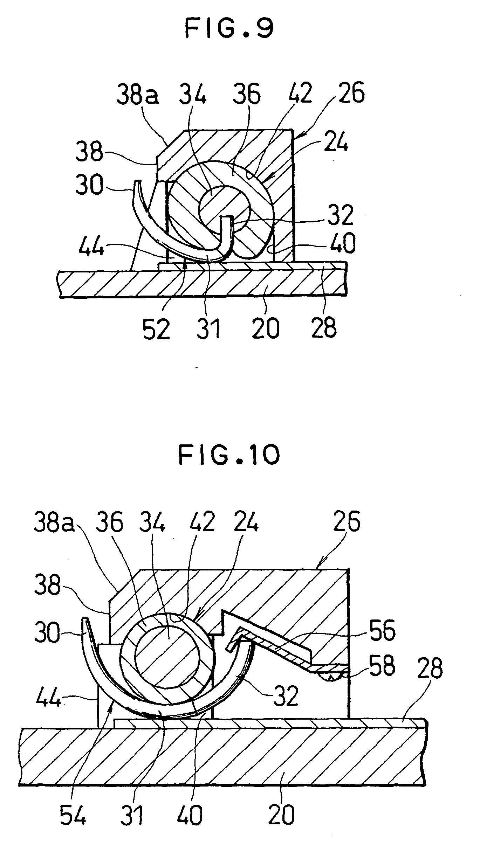

Referring to Fig. 9, a probe 52 is bent upward at the needle tail portion 32 having an insulated layer, bent upward in the needle tail portion 32 and forms a J-like shape to be inserted into the needle presser 24, and is pressed against the conductive portion 28 at the arc-shaped rear end portion of its deformed potion 31. According to this embodiment, too, since the needle tail portion 32 is prevented from moving relative to the needle presser 24, the region of the probe 52 in contact with the conductive portion changes toward the needle tip but does not move around the needle presser 24 in its circumferential direction.

Namely, when the probe 52 is pressed down by the device to be inspected, force to retract the probe 52 along the outside surface of the deformed portion 31 acts on the probe 52. However, since the rear end portion is inserted into the needle presser 24, the probe 52 is elastically deformed so as to increase the radius of curvature of the deformed portion 31, without retracting in the circumferential direction of the needle presser 24. As a result, even when the probe 52 is used, an action of effect similar to the case of using the probe 22 can be obtained.

Referring to Fig. 10, a probe 54 has its tail end (particularly its tail end face) abut against a stopper 56 formed from a leaf spring for prevention of retraction. The stopper 56 is provided in each probe group and is attached to the cover 26 with a plurality of screw members 58. The stopper 56 can be formed of an insulated plate material but may be a conductive plate material having an insulated layer formed on its surface, and further, if the tail end of each probe is non-conductive, may be a conductive plate material.

Also according to the embodiment shown in Fig. 10, the probe 54, being prevented from moving backward relative to the needle presser 24 with its tail end abutting against the stopper 56, does not move around the needle presser 24 in its circumferential direction. For this reason, when the probe 54 is pressed down by the device to be inspected, the probe 54 is elastically deformed so as to increase the radius of curvature of the deformed portion 31. As a result, even when the probe 54 is used, an action and effect similar to the case of using the probe 22 can be obtained.

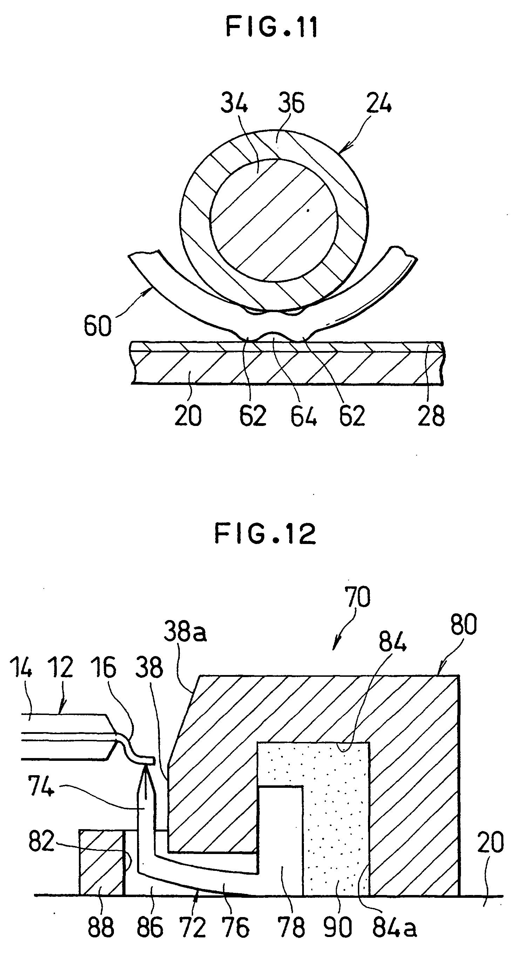

Referring to Fig. 11, a probe 60 has convex portions 62 and a concave portion 64 at the region in contact with the conductive portion 28. The probe 60 is pressed against the conductive portion 22 in the convex portions 62. As a result, in case of the probe 60, the region having the convex portions 62 acts as a deformed portion, i.e., an arc-shaped curved portion deformed in relation to the needle tail portion.

According to the probe 60, the convex portions 62 are engaged with the conductive portion 28, so that, due to the engagement of the convex portions 62 and the conductive portion 28, the movement of the probe 60 relative to the needle presser 24 makes the tail end of the probe 60 abut against the end face of the slot, the inner face of the recess or the stopper such as the above-mentioned probe, and is more surely prevented. As a result, the electrical connection between the conductive portion 28 and each probe 60 is more ensured.

In each of the embodiments mentioned above, it is possible to use a semi-cylindrical needle presser instead of the needle presser 24 making use of a part of the cylindrical portion as the convex portion, or to use a square pole-shaped member having a semi-cylindrical convex portion in one surface as a needle presser. Also, the needle presser may be a mere non-conductive bar-like member using no elastic material, so long as the needle presser has non-conductivity at least in its outer surface.

Referring to Fig. 12, an auxiliary apparatus 70 uses an approximately U-shaped probe 72. The probe 72 is formed to be approximately U-shaped by a needle front portion 74, a needle base portion, i.e., an arc-shaped deformed portion 76, and a needle tail portion 78. The needle front portion 74 and the needle tail portion 78 extend linearly upward respectively from the front end and the rear end of the deformed portion 76 approximately parallel to each other. The needle front portion 74 and the deformed portion 76 are made conductive at least in their outer peripheral surfaces.

The deformed portion 76 extends diagonally upward from the side of its rear end toward the side of the needle front portion 74 and curved in a convex form diagonally downward with a great radius of curvature. The needle tail portion 78 may be either conductive or non-conductive. The needle tail portion 78 has a larger sectional shape than the needle front portion and the deformed portion 76. The probe 72 has either a circular or a rectangular transverse sectional shape. For this reason, the probe 72 has a shape of either a fine line or a strip.

A cover 80 of the connecting apparatus 70 includes an opening 38 formed in the center to accommodate the device 12, a plurality of slots 82 extending from the opening 38 outwardly and in parallel, and a plurality of recesses 84 formed outside the opening 38 to extend continuously in the arranging direction of the slots 82. Such a cover 80 can be formed from a non-conductive material. The opening 38 is the same as the opening 38 of the cover 26 of the auxiliary apparatus 10. Therefore, the upper portion of the opening 38 is made to be an inclined surface 38a.

The slots 82 are grooves for accommodating a part of at least the deformed portion 76 of the probe 72, and accordingly, the number of the provided slots 82 is the same as that of the probes 72 in the illustrated embodiment. The slots 82 are divided into a plurality of slot groups to correspond to each side of the rectangle forming the opening 38, and are formed in parallel in each slot group. Each slot 82 opens at the side of the base plate 20, that is, downward and at the side of the opening 38 in the tip end upper portion.

Adjacent slots 82 are partitioned by a partition wall 86. The end portions of adjacent partition walls 86 at the side of the opening 38 are connected by a wall portion 88 closing the corresponding end portions of the slots 82. It is possible, however, not to connect the end portions at the side of the opening 38 of adjacent partition walls 86 but to open the corresponding end portions of the slots 82.

The recesses 84 correspond to each side of the rectangle forming the opening 38 and extend continuously along the corresponding sides. In the illustrated embodiment, actually four recesses 84 are provided. Each recess 84 is a groove having a rectangular sectional shape accommodating a needle presser 90 and opens at the sides of the rear end and the base plate 20 of the corresponding slot 82. Each recess 84 has a rectangular sectional shape.

Each needle presser 90 is formed in a rectangular sectional shape of an elastic material such as rubber and is fitted into the recess 84. In the illustrated embodiment, the needle presser 90 has a groove communicated with the slot 82 for receiving a part of the deformed portion 76 and the needle tail portion 78 of the probe 72. Such a groove may, however, be formed in the cover 80 or has to be formed neither in the cover 80 nor in the needle presser 90, depending on the shape and the dimension of the probe.

The connecting apparatus 70 can be assembled by arranging each needle presser 90 in the recess 84, arranging each probe 72 such that the deformed portion 76 of the probe 72 comes in the slot 82 and that the needle tail portion 78 comes in the recess 84, overlapping the probe 72, the needle presser 90 and the cover 80 on the base plate 20 in that state, and mounting the cover 80 on the base plate 20 with a plurality of screw members such as bolts in that state.

In the state of being assembled into the connecting apparatus 70, each probe 72 is pressed against the wiring portion of the base plate 20 at the rear end portion of the deformed portion 76 by the needle presser 90. Also, the needle tip of each probe 72 projects upward from the slot 82 into the opening 38, the needle tail portion 78 of each probe 72 is pressed against the inner wall surface forming the slot 82 by the needle presser 90, and the rear end face of each probe 72 is received by the needle presser 90. As a result, each probe 72 is pressed against the base plate 20 at the rear end side of the deformed portion 76.

When the needle tip of the needle front portion 74 is pressed against the electrode portion 16 of the device 12, the probe 72 itself is elastically deformed and deforms the needle presser 90 so that the needle front portion 74 and the needle tail portion 78 may spread. Thereby, the probe 72, giving at its needle tip a scraping action to the electrode portion 16, removes a part of a film such as an oxide film existing in the surface of the electrode 16.

The force directed to retract the probe 72 is the force directed to displace the probe 72 along the arc-shaped outside face of the deformed portion 76, but the probe 72 is prevented from retracting because its tail end face is indirectly in contact with the inner face 84a of the recess 84 through the needle presser 90. However, the probe 72 may be pressed against the base plate 20 by the needle presser 90, by making the rear end face of the probe 72 indirectly contact with the inner face 84a of the recess 84 by the needle presser 90.

The connecting apparatus 70 not only gives an action and effect similarly to the connecting apparatus 10 but also presses the needle tail portion 78 against the inner face of the recess 84 by the needle presser 90, so that the probe 72 is more stabilized.

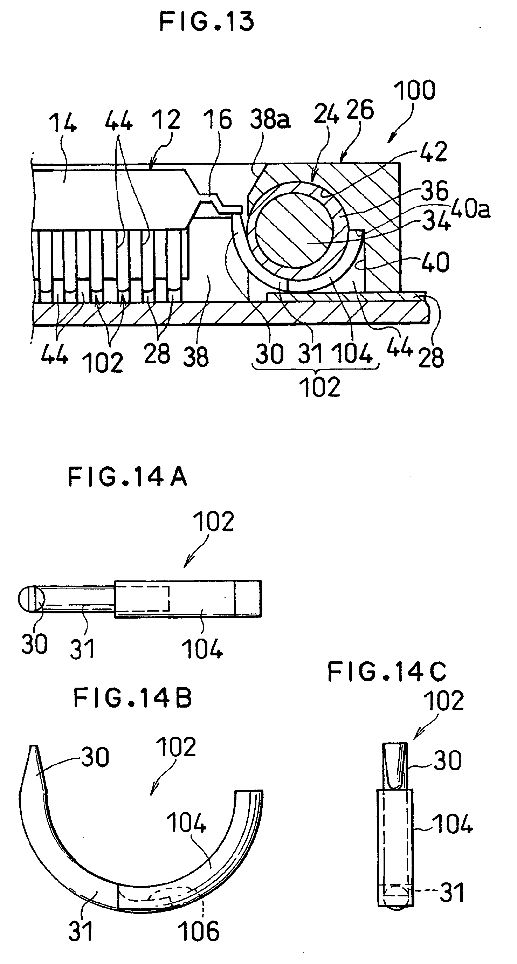

Referring to Fig. 13, a connecting apparatus 100 uses in the connecting apparatus 10 shown in Figs. 1 through 6 a plurality of probes 102 having such a shape as shown in Fig. 14 instead of using probes extending integrally from the tip end to the rear end as in the auxiliary apparatus 10.

Each probe 102 is composed of a needle front portion 30, a deformed portion 31 and a needle tail portion 104 combined with the rear end of the deformed portion 31, and is curved in an arc-like shape at the same curvature over the entire area from the front end to the rear end. The needle tail portion 104 is formed of an insulated resin material such as synthetic resin material.

The tip end portion of the needle front portion 30 of each probe 102 is a tapered portion getting thinner toward the needle tip, and the portion backward from its needle tip is a bar-like portion having a circular sectional shape. The rear end portion of the deformed portion 31 of each probe 102 has a cutout 106 at the upper side for enhancing the force in combining with the needle tail portion 104.

The inside of the rear end of the deformed portion 31 of each probe 102 is covered with the needle tail portion 104, while the outside portion is exposed without being covered with the needle tail portion 104. Such a probe 102 can be fabricated by using an insulated material such as synthetic resin for the needle tail portion 104. The end face of the probe 102 is in direct contact with the deep bottom face, i.e., the end face 40a of the slot 40.

The connecting apparatus 100 using a plurality of probes 102 can be, as shown in Fig. 13, assembled similarly to the connecting apparatus 10 except that the deformed portion 31 of each probe 102 is pressed against the wiring portion 28 outside the portion combined with the needle tail portion 104, acts similarly to the connecting apparatus 10 and gives a similar effect as the connecting apparatus 10.

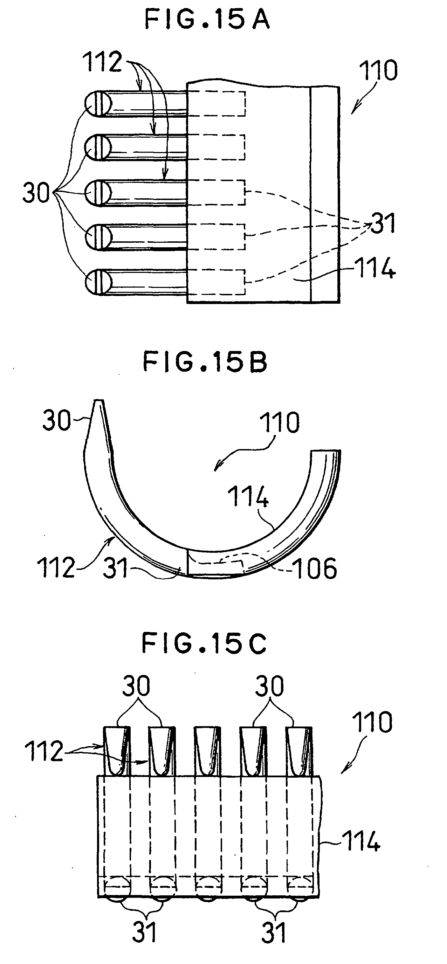

In the connecting apparatus 10 or 100, instead of using a plurality of independent probes 112, one or more needle assemblies 110 with a plurality of probes combined at the needle tail portions can be used, as shown in Fig. 15.

Each probe 112 used in the needle assembly 110 is formed similarly to the probe 102 shown in Fig. 14 except that it is combined with the needle tail portion 114 common to the plurality of probes 112 in the rear end of the deformed portion 31.

Therefore, the needle front portion 30 and the deformed portion 31 of each probe 112 are the same as those of the probe 102 shown in Fig. 14, and the deformed portion 31 of each probe 112 has a cutout portion 106 at its upper side for enhancing the combining force with the common needle tail portion 114. The common needle tail portion 114 has an elongate shape curved like a shallow chute made of a non-conductive material, with the same curvature as the needle front portions 30 and the deformed portions 31 of the probes 112.

The common needle tail portion 114 may be made common in each probe group of each side of the rectangle formed by the opening 38 of the aforementioned cover 26, or may be made common to every two or more probes. Also, since adjacent probes 112 are connected to the common needle tail portion 114 in the deformed portions 31, the cover 26 of the connecting apparatus using the probe assembly 110 includes neither the slot 40 nor the partition wall 44. It may, however, include a slot for receiving only the needle front portion 30 and the deformed portion 31 of each probe 112.

Therefore, the slot 40 is a continuous common slot. It is, however, possible to separate the portion receiving only the needle tip portion 30 and the deformed portion 31 of each probe 112 from the common slot 40 by the partition wall.

While the inside of the rear end portion of each deformed portion 31 is covered with the common needle tail portion 114, the outside thereof is not covered with the common needle tail portion 114 but is exposed. The needle assembly 110 can also be manufactured by fabrication using an insulated material such as synthetic resin as the common needle tail portion 114.

The connecting apparatus for testing using the needle assembly 110 can be assembled and utilized similarly to the connecting apparatus 10 and 70 and, besides bringing about actions and effects similarly to the connecting apparatus 10, the needle tail portions of the probes 112 are combined in common, so that there is such a merit as manufacturing and assembling of the needle assembly 110 are facilitated.

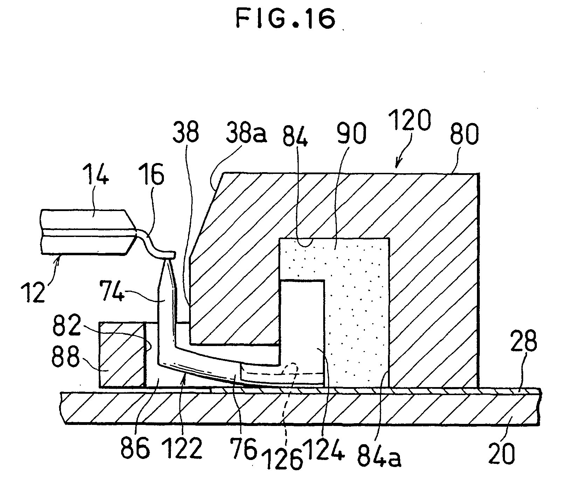

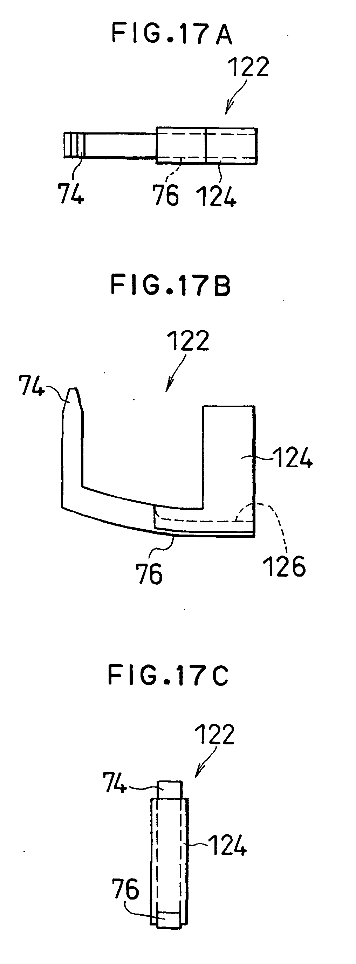

Referring to Fig. 16, a connecting apparatus 120 uses a plurality of probes 122 having such a shape as shown in Fig. 17, instead of using the probes 72 integrally extending from the tip ends to the rear ends in the connecting apparatus 70 shown in Fig. 12.

Each probe 122 is formed to have an approximately U-shape by a needle front portion 74, a deformed portion 76 and a needle tail portion 124 as shown in Fig. 17. The needle front portion 74 and the deformed portion 76 are respectively the same as those of the probe 72 shown in Fig. 12. Therefore, the needle front portion 74 and the deformed portion 76 are formed in an L-shape such that the needle front portion 74 extends linearly upward from the tip end of the deformed portion 76.

The deformed portion 76 of each probe 122 has a cutout portion 126 at its upper side for enhancing the combining force with the needle tail portion 124. The upper side (inside) portion of the rear end of the deformed portion 76 is covered with the needle tail portion 124, while the lower side (outside) is not covered with the needle tail portion 124 but is exposed.

The needle tail portion 124 is formed of a non-conductive material such as synthetic resin and extends linearly upward from the rear end of the deformed portion 76 parallel to the needle front portion 74.

The probe 122 can also be manufactured by fabrication using an electrically insulated material such as synthetic resin for the needle tail portion 124. The connecting apparatus 120 can also be utilized similarly to the connecting apparatus 10, 70 and 100 and, besides, can give actions and effects similarly to the connecting apparatus 10, 70 and 100.

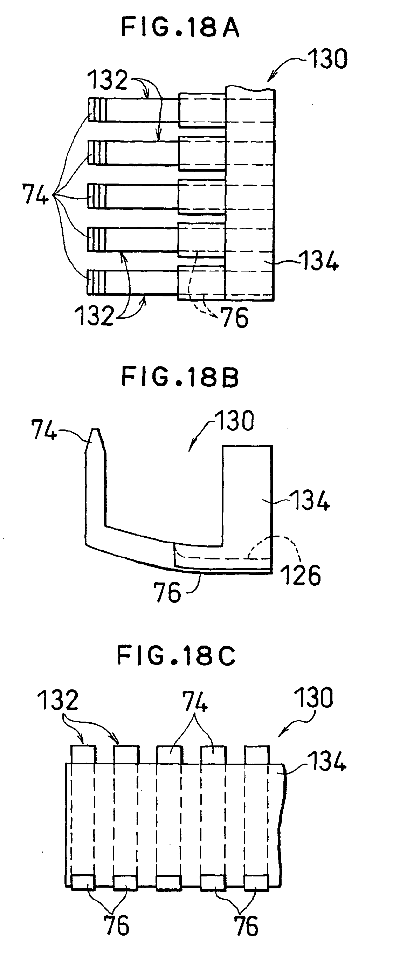

In the connecting apparatus 70 or 120, one or more needle assemblies 130 having a plurality of probes combined with the needle tail portion may be used as shown in Fig. 18, instead of using a plurality of independent probes.

Each probe 132 used in the needle assembly 130 is formed similarly to the probe 122 shown in Fig. 17 except being combined with the common needle tail portion 134 at the rear end of the deformed portion 76.

The deformed portion 76 of each probe 132 has, therefore, a cutout portion 126 at its upper side for enhancing the combining force with the common needle tail portion 134, which is made to have a comb-like shape of a non-conductive material.

The needle assembly 130 is approximately U-shaped by the needle front portions 74, the deformed portions 76 and the common needle tail portion 134 of the probes 132. The cover of the connecting apparatus using the needle assembly 130 does not have to include a wall portion 86 or 88 shown in Fig. 12.

The deformed portion 76 of each probe 132 has the cutout portion 126 at its upper side for enhancing the combining force with the needle tail portion 124. The upper side (inside) portion of the rear end of the deformed portion 76 is covered with the needle tail portion 124, while the lower side (outside) is not covered with the needle tail portion 124 but is exposed.

The connecting apparatus using the needle assembly 130 can be assembled and utilized similarly to the connecting apparatus 70 and 120, and since the needle tail portions 134 of the probes 132 are combined in common, there is such a merit as manufacturing of the needle assembly 130 as well as assembling it into the connecting apparatus are facilitated besides bringing about actions and effects similarly to the connecting apparatus 70 and 120.

In the above-mentioned embodiment, the cover is formed by a single member, but it may be formed by a plurality of members. For example, the cover may be formed by a plate-like member having the opening 38 and a member having a slot and a recess, or by a plate-like member having the opening 38, a member having a slot, and a member having a recess. Further, it may be formed by a plate-like member having the opening and a recess and a member having a slot.

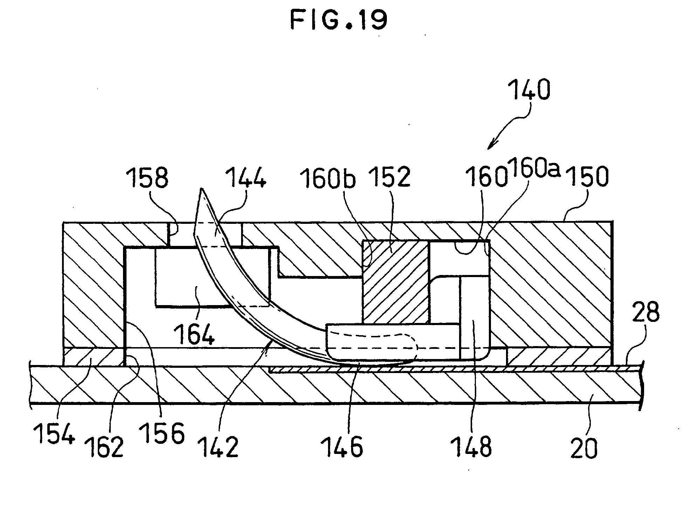

Referring to Fig. 19, the connecting apparatus 140 uses a plurality of probes 142 similar to the probe 122 shown in Fig. 17. Each probe 142 is generally curved like an arc from the needle front portion 144 to the rear end of the deformed portion 146. At least the surface of the needle front portion 144 and the deformed portion 146 of each probe 142 has conductivity.

The needle tail portion 148 is formed to be L-shaped by a non-conductive material such as synthetic resin and is fixed at the deformed portion 146. The upper side (inside) portion of the rear end of the deformed portion 146 is covered with the needle tail portion 148, while the lower side (outside) is not covered with the needle tail portion 148 but is exposed.

The needle tail portion 148 is independent in each probe 142, but may be made a common needle tail portion 148 to adjacent probes. In order to enhance the combining force between the deformed portion 146 and the needle tail portion 148, a cutout portion 126 may be formed at the upper side of the deformed portion 146 as shown in Fig. 17 or 18.

The connecting apparatus 140 has a plurality of elongated covers 150 where a plurality of probes 142 are juxtaposed, a long needle presser 152 disposed inside each cover 150 and a spacer 154.

Each cover 150 is essentially a cover base. Therefore, an auxiliary member having the opening 38 is either integrally provided on the cover 150 or assembled by screw members. Each cover 150 includes a first recess 156 opening at the side of the base plate 20, a slot 158 communicating with the first recess 156, and a second recess 160 opening at the side of the first recess 156, as one example is shown in Fig. 19. The first recess 156, the slot 158, and the second recess 160 extend continuously in the arranging direction of the probes 142.

The needle presser 152 is formed of an elastic material such as hard rubber to be rectangular in sectional shape and disposed in the first and second recesses 156 and 160. The spacer 154 includes an opening 162 of approximately the same dimension as the first recess 156, and is disposed between the cover 150 and the base plate 20 such that the first recess 156 and the opening 162 are in alignment with each other. Consequently, the spacer acts as part of the cover 150, while the opening 162 acts as part of the recess 154.

The probes 142 are juxtaposed in the first recess 156. The probes 142 are juxtaposed such that the needle front portions 144 project upward through the slot 158 and that the needle tail portions 148 extend into the second recess 160, and the rear end of the deformed portions 146 are pressed against the wiring portions 28 of the base plate 20. The probes 142 are in direct contact with the inner face 160a of the second recess 160 at the tail end face so as to be prevented from retracting.

Each cover 150 is overlapped on the base plate 20 through the spacer 154, with the probes 142 and the needle presser 152 accommodated, to be assembled into the base plate together with the spacer 154 with suitable means such as a screw member. Thereby, the probes 142, the covers 150, the needle presser 152 and the spacer 154 are made as a unit.

The connecting apparatus 140 respectively use such units. Each unit is assembled into the common base plate 20 so that the arranging direction of the needle tips of the probes 142 may coincide with the arranging direction of the electrode portion of a device to be inspected and that the needle tips of the probes of the confronting units may oppose each other. Thereby, the electrode portion of the device to be inspected is received by the needle tip of each probe 142.

In the illustrated example, the cover 150 does not include a slot for receiving the deformed portion 146 of each probe 142. Therefore, each probe 142 has a spacer 164 abutting against the adjacent probe 142 at the needle front portion 144. The spacer 164 is formed of a non-conductive material such as synthetic resin like a plate and is fixed at one side of the needle front portion 144. However, the spacer 164 and the probe 142 may be integrally formed such that the needle front portion 144 of each probe 142 penetrates the corresponding spacer 164.

In the connecting apparatus 140, when the device to be inspected is pressed against the probe 142 and the probe 142 is subjected to overdrive at its needle tip, the probe 142 is elastically deformed so as to increase the radius of curvature of the deformed portion 146 in a state of being prevented from retracting along the deformed portion 146 and presses the needle presser 152 against the inner face 160b at the opposing side to the inner face 160a of the recess 160. Thereby, the portion of the probe 142 in contact with the conductive portion 28 changes toward the needle point side. Further, the probe 142 retracts slightly relative to the conductive portion 28 due to the upward displacement of the contacting portion of the inner face 160a. This retraction, however, does not prevent the probe 142 from being elastically deformed for the same reason as in the case of the connecting apparatus 10.

While the probe 142 effectively gives a scraping action to the electrode portion of the device to be inspected and the cover 150 does not include a slot for receiving the deformed portion 146 of the probe 142, there is no fear that the adjacent probes 142 are brought into contact with each other at the needle tip side when the needle tip is pressed against the electrode portion of the device to be inspected.

The spacer 164 may be provided in the connecting apparatus using the aforementioned probes 22, 50, 52, 54, 60, 72, 102, 112, 122, and 132. Also, instead of providing the spacer 164 in each probe, a plurality of adjacent probes may be connected by a non-conductive material such as synthetic resin at a region at the needle tip side.

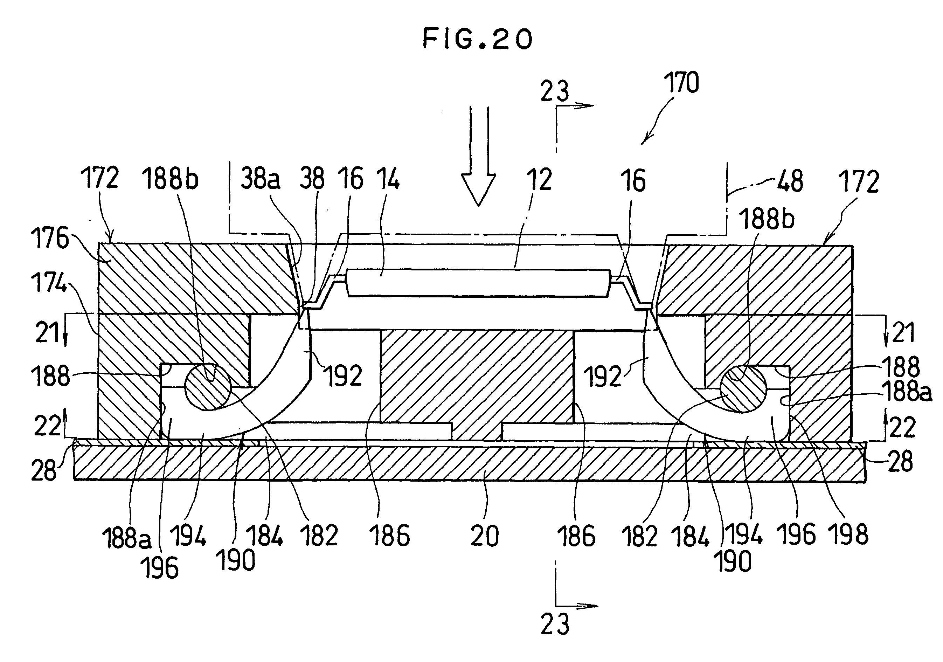

Examples of deformation of the connecting apparatus 140 are shown in Fig. 20 through Fig. 22.

Referring to Figs. 20 through 22, a connecting apparatus 170 uses a halved cover 172. The device 12 tested by this connecting apparatus 170 has a plurality of electrode portions 16 at both sides in the cross direction. The electrode portions 16 are divided into a plurality of electrode groups corresponding to the widthwise sides and juxtaposed in each electrode group.

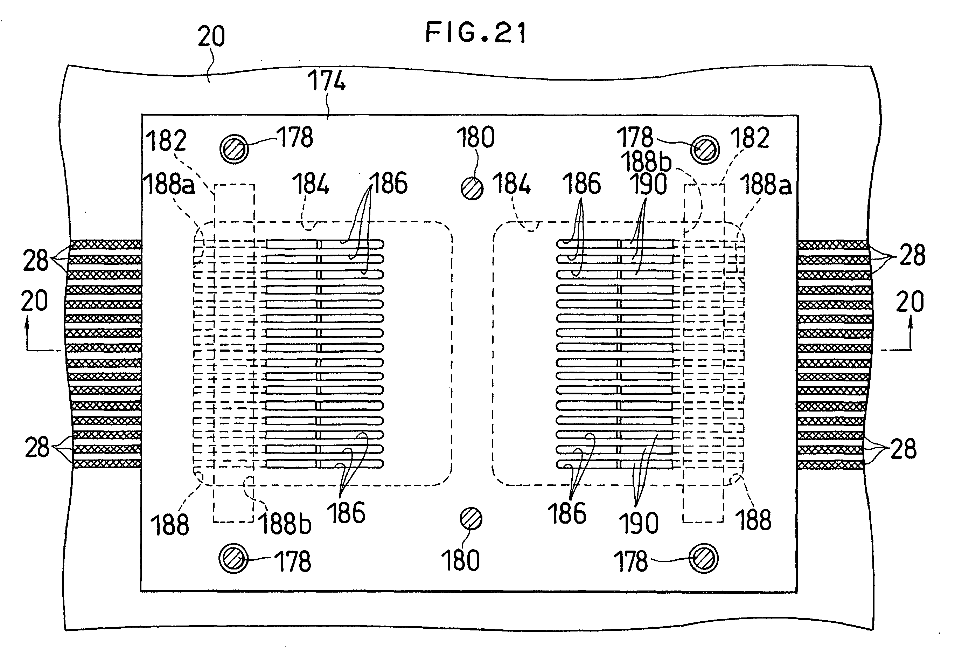

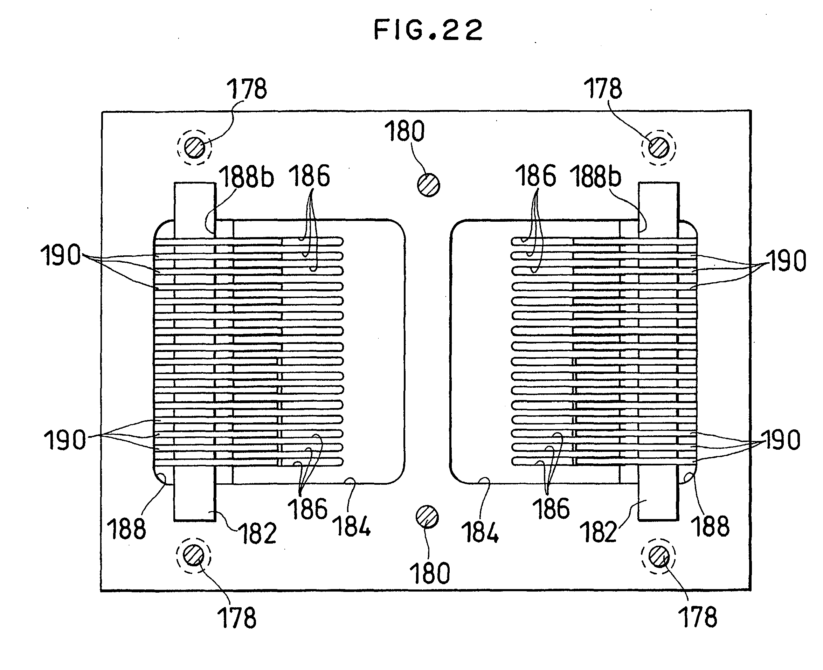

A cover 172 is divided into first and second members 174, 176 as shown in Fig. 20 and are assembled into the base plate 20 in a mutually overlapped state with a plurality of screw members 178 and a plurality of positioning pins 180 (see Figs. 21 and 22 as regards both cases).

The cover base portion, i.e., the first member 174 is integrated with the cover 150 and the spacer 154 in Fig. 19. Consequently, the first member 174 includes an opening or the first recess 184 opening at the side of the base plate 20, a plurality of slots 186 communicating with the first recess 184, and a second recess 188 where a needle presser 182 circular in sectional shape is disposed, in each electrode group. On the other hand, an auxiliary member for the second member 176 includes the opening 38 having the inclined plane 38a.

The slots 186, besides communicating with the first and second recesses 184, 188, penetrates the first member 174 in its thickness direction. The second recess 188 extends continuously in the arranging direction of a plurality of probes 190 and opens at the side of a base plate 28.

Each probe 190 is a plate-like probe (a blade-type needle) formed approximately in J-shape by a conductive metal material. The probe 190 has a needle front portion 192 with a needle tip, a deformed portion 194 integrally continuous from the rear end of the needle front portion 192, and a needle tail portion 196 integrally continuous from the rear end of the deformed portion.

The needle front portion 192 penetrates the slot 186 and projects its needle point inside the opening 18. The deformed portion 194 is curved like an arc and partially received in the first recess 184. The needle tail portion 196 has its rear end face brought into contact with the inner face 188a of the second recess 188 to be prevented from retracting.

The needle presser 182 is formed like a bar of an elastic material such as rubber in the illustrated example and extends in the longitudinal direction of the second recess 188. The needle presser 182 presses the probe 190 in a state of being assembled into the auxiliary device 170 such that the probe 190 is brought into contact with the wiring portions 28 at the deformed portion 194.

In the connecting apparatus 170, the blade-type probe 190 is used, so that when the device to be inspected is pressed against the tip end of the probe 190, the needle presser 182 is pressed against the arc-shaped inner face 188b with the needle tail portion 196. Thereby, the probe 190 is displaced so that the portion in contact with the conductive portion 28 changes toward the needle tip side.

At this time, the probe 190, pressed against the inner face 180 at the rear end by restoring force of the needle presser 182, slides slightly relative to the conductive portion 28. This slide, however, does not prevent such a displacement of the probe 190 as the portion in contact with the conductive portion 28 changes toward the needle tip side. As a result, the connecting apparatus 170 also gives an action and effect similar to the case of the connecting apparatus 140.

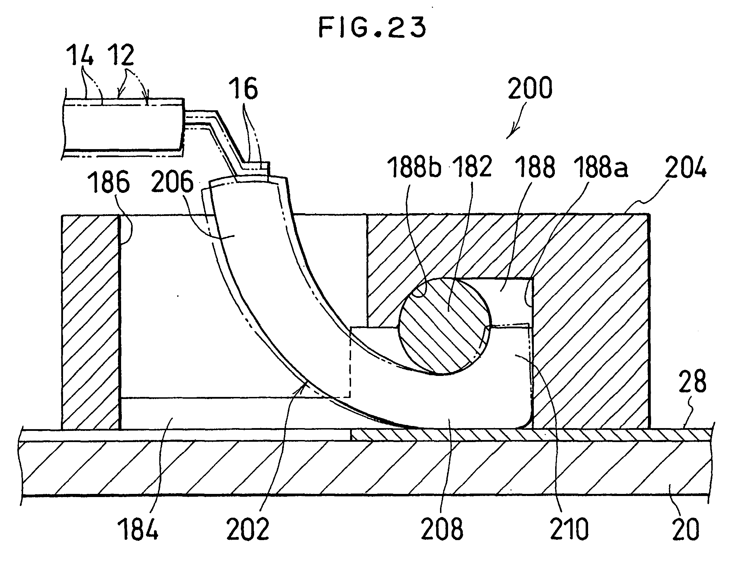

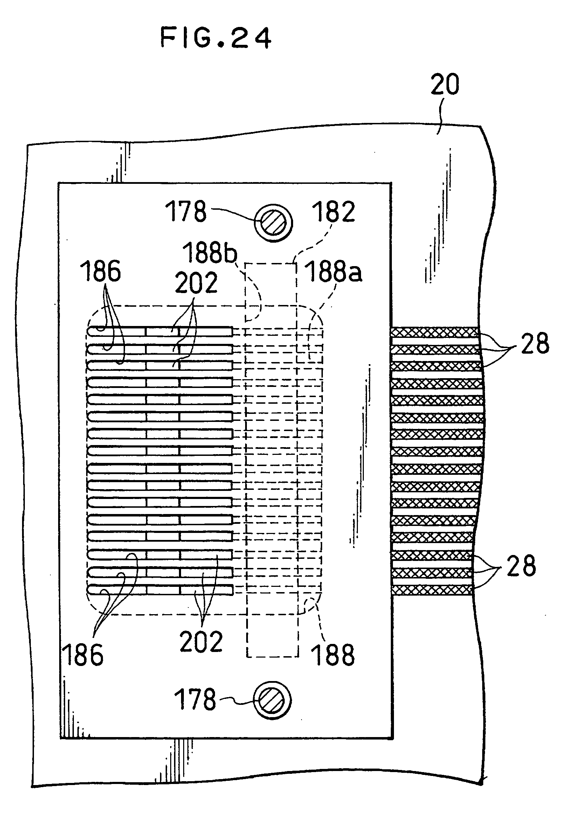

Other examples of deformation of the connecting apparatus 140 are shown in Figs. 23 and 24. The connecting apparatus 200 disposes a plurality of units on the common base plate, including a plurality of plate-like probes 202 formed in substantially J-like shape of a conductive metal material, a cover 204 corresponding to the region rightward from the line 23-23 in Fig. 20 in the first member 174, and the same needle presser 182 as in case of the connecting apparatus 170.

Each probe 202 is an ax-shaped needle with its needle tip extending in the longitudinal direction in Fig. 23, and a needle front portion 206 has a needle tail portion 210 in contact with an arc-shaped deformed portion 208 and an inner face 188a. The probe 202 is disposed in a cover 204 similar to the case of probe 190 of the connecting apparatus 170.

The connecting apparatus 200 also has a plurality of units assembled into the common base plate 20 as in the case of the connecting apparatus 140. Therefore, the connecting apparatus 200 also gives an action and effect similar to the case of the connecting apparatus 140, 170. In the connecting apparatus 40 or 200, a second member having the opening 38 of the connecting apparatus 170 may be disposed in common on the covers 150 or 204.

In the connecting apparatus 140, 170, 200, the first recess 156, 184 may be made a recess composed of a plurality of grooves for receiving at least a part of the deformed portion of the probes individually corresponding to the probes 142, 190. In this case, such grooves extend at intervals in parallel in the longitudinal direction of the needle presser. The first and second recesses 156 and 160 as well as 184 and 188 may be one recess. In the connecting apparatus 140, instead of making the first recess 156 a recess composed of a plurality of grooves, the opening 162 of the spacer 154 may be made such a groove.

The present invention is not limited to the above-mentioned embodiments. For example, the probes may be formed to have such simple shapes as an arc-shape, a one-side open rectangular shape, a U-shape, An L-shape, a V-shape, a W-shape, etc. Also, the probes may be used with the shapes turned upside down in the foregoing embodiments.

It will be apparent to those skilled in the art that various modifications and variations can be made in the apparatus and method of the present invention without leaving the scope of the invention. Thus, it is intended that the present invention cover the modifications and variations of this invention, provided they come within the scope of the appended claims.

## Claims

1. A connecting apparatus for electrically connecting a plurality of electrode portions (16) of a device (12) to be tested and a plurality of conductive portions (28) formed on one face of a base plate (20) when the device (12) to be tested is pushed toward said base plate (20) by a presser (48), comprising:
a plurality of probes (22, 50, 52, 54, 60, 72, 102, 112, 122, 132, 142, 190, 202);
and assembling equipment (24, 26, 80, 90, 150, 152, 154, 172, 182, 204) for assembling said probes in parallel to said base plate, such that said probes are arranged at intervals in one direction,
wherein each probe (22, 50, 52, 54, 60, 72, 102, 112, 122, 132, 142, 190, 202) includes a probe base portion (31, 76, 146, 194, 208) which is curved so as to have an inside portion and an outside portion to be brought into contact with the plurality of the conductive portions, a probe front portion (30, 74, 144, 192, 206) continuous with one end of said probe base portion and a probe tail portion (32, 78, 104, 114, 124, 134, 148, 196, 210) continuous with the other end of said probe base portion,
wherein said assembling equipment (24, 26, 80, 90, 150, 152, 154, 172, 182, 204) is provided with at least a cover to be assembled with said base plate (20), said cover having a recess (42, 84, 160, 188) extending in said one direction and having a plurality of slots at intervals in said one direction,
and a needle presser (24, 90, 152, 182) received in the recess (42, 84, 160, 188) for pressing said probes so as to bring at least a part of said probe base portions or said probe tail portions of said probes into contact with the conductive portions (28) of said base plate (20) and extending in said one direction,
**characterized in that**
said probe front portion (30, 74, 144, 192, 206) has a tip end for pressing against said electrode portion when said device (12) to be tested is pressed toward said base plate (20), wherein each probe is to penetrate said slot (40, 82, 158, 186) to project its tip end out of said slot (40, 82, 158, 186),
said assembling equipment (24, 26, 80, 90, 150, 152, 154, 172, 182, 204) is further provided with a retraction preventive portion (40a, 56, 84a, 160a, 188a) for preventing said probes from retracting when said electrode portion is pressed against the tip, and
each probe has the tail portion brought into contact with said retraction preventive portion (40a, 56, 84a, 160a, 188a) and
has one of an arc-like shape, a U-like shape or a J-like shape so as to scrape off part of the surface of said electrode portion with the tip end when said electrode portion is pressed against said tip end,
whereby even if the probe is subjected to an overdrive action, the probe would not retract.

2. A connecting apparatus according to claim 1, wherein said recess is opened toward said base plate and said needle presser.

3. A connecting apparatus according to claim 2, wherein said needle presser (24, 152, 182) abuts against said inside portions of at least said base portion (31, 76, 146, 194, 208) of said probes.

4. A connecting apparatus according to claim 3, wherein said needle presser (24, 182) has a cylindrical shape and is made electrically insulated at least in its peripheral surface.

5. A connecting apparatus according to claim 3, wherein said needle presser (24) includes a cylindrical presser bar (34) and an elastic material layer (36) formed of an electrical insulation material around said presser bar.

6. A connecting apparatus according to claim 2, wherein said recess (42, 84, 160, 188) has an arc-shape or rectangular shape in section and opens at least toward said base plate (20).

7. A connecting apparatus according to claim 2, wherein said cover (26, 80, 150, 172, 204) further includes an opening (38) for receiving said device (12) .

8. A connecting apparatus according to claim 2, wherein said needle presser (90, 152, 182) further presses the probe tail portion of said probe against a part of the inner face defining said recess (84, 160, 188).

9. A connecting apparatus according to claim 7, wherein each probe (22, 50, 52, 54, 60, 72, 102, 112, 122, 132, 142, 190, 202) has its needle tip projected into said opening (38).

10. A connecting apparatus according to claim 1, wherein the probe tail portions (114, 134) of two or more probes (112, 132) are integrally formed of an electrically non-conductive material and wherein said probes (112, 132) are brought into contact with said conductive portion (28) at their base portions.

11. A connecting apparatus according to claim 1, wherein said outside portion of said probe (22, 50, 52, 54, 60, 72, 102, 112, 122, 132, 142, 190, 202) extends in an arc-like shape so as to contact with said conductive portion (28) when at least said electrode portion (16) is pressed against the tip end.

12. A connecting apparatus according to claim 11, wherein said probe is elastically deformable such that, the greater a pressing force by said device (12) to be tested becomes, the more the portion of said outside region in contact with said plurality of conductive portions (28) moves toward said tip end.

13. A connecting apparatus according to claim 1,
wherein each slot (40, 82, 158, 186) is opened toward said base plate (20) and toward the device (12) to be tested and communicates to the recess (42, 84, 160, 188).

14. A connecting apparatus according to claim 1, wherein said retraction preventive portion includes a part of the inner face defining said recess.

15. A connecting apparatus according to claim 1, wherein each probe is received in said slot at a part of said deformed portion (31, 76).

16. A connecting apparatus according to claim 15, wherein said retraction preventive portion includes a part of the inner face defining said recess (42, 84, 160, 188) or the end face defining a part of said slot (40, 82).

17. A connecting apparatus according to claim 1, wherein said retraction preventive portion is provided with a stopper (56) disposed in said cover (26).

18. A connecting apparatus according to claim 1, wherein said probe (22, 50, 52, 54, 60, 72, 102, 112, 122, 132, 142, 190, 202) includes a rear end face in contact with said retraction preventive portion.

## Patentansprüche

1. Verbindungsvorrichtung zum elektrischen Verbinden von mehreren Elektrodenabschnitten (16) eines zu testenden Bauteils (12) mit mehreren auf einer Fläche einer Grundplatte (20) ausgebildeten leitfähigen Abschnitten (28), wenn das zu testende Bauteil (12) mittels eines Pressers (48) auf die Grundplatte (20) hin gedrückt wird, umfassend:
mehrere Tester (22, 50, 52, 54, 60, 72, 102, 112, 122, 132, 142, 190, 202);
und eine Montageeinrichtung (24, 26, 80, 90, 150, 152, 154, 172, 182, 204), um die Tester parallel zueinander an der Grundplatte zu montieren, so daß die Tester in Intervallen in einer Richtung angeordnet sind,
wobei jeder Tester (22, 50, 52, 54, 60, 72, 102, 112, 122, 132, 142, 190, 202) einen Testergrundabschnitt (31, 76, 146, 194, 208) aufweist, der gekrümmt ist, so daß er einen innenseitigen Abschnitt und einen außenseitigen Abschnitt aufweist, um mit den mehreren leitfähigen Abschnitten in Kontakt gebracht zu werden, einen Testervorderabschnitt (30, 74, 144, 192, 206), der durchgängig mit einem Ende des Testergrundabschnitts ausgebildet ist, sowie einen Testerrückabschnitt (32, 78, 104, 114, 124, 134, 148, 196, 210), der durchgehend mit dem anderen Ende des Testergrundabschnitts ausgebildet ist,
wobei die Montageeinrichtung (24, 26, 80, 90, 150, 152, 154, 172, 182, 204) wenigstens mit einer Abdeckung versehen ist, die mit der Grundplatte (20) montierbar ist, wobei die Abdeckung eine Aussparung (42, 84, 160, 188) aufweist, die sich in die eine Richtung erstreckt, und in Intervallen in der einen Richtung mehrere Einschübe aufweist,
und einen in der Aussparung (42, 84, 160, 188) aufgenommenen Nadelpresser (24, 90, 152, 182), um die Tester derart zu pressen, daß wenigstens ein Teil der Testergrundabschnitte oder der Testerrückabschnitte der Tester mit den leitfähigen Abschnitten (28) der Grundplatte (20) in Kontakt kommen, die sich in die eine Richtung erstrecken,
**dadurch gekennzeichnet, daß**
der Testervorderabschnitt (30, 74, 144, 192, 206) ein Spitzende aufweist, um gegen den Elektrodenabschnitt zu pressen, wenn das zu testende Bauteil (12) gegen die Grundplatte (20) gepreßt wird, wobei jeder Tester in den Einschub (40, 82, 158, 186) eindringen soll, so daß sein Spitzende aus dem Einschub (40, 82, 158, 186) hervorsteht,
wobei die Montageeinrichtung (24, 26, 80, 90, 150, 152, 154, 172, 182, 204) ferner versehen ist mit einem Rückzugsverhinderungsabschnitt (40a, 56, 84a, 160a, 188a), um zu verhindern, daß sich die Tester, wenn der Elektrodenabschnitt gegen die Spitze gedrückt wird, sich zurückziehen, und
wobei bei jedem Tester der Rückabschnitt mit dem Rückzugsverhinderungsabschnitt (40a, 56, 84a, 160a, 188a) in Kontakt gebracht wird und
jeder Tester eine bogenförmige Gestalt, eine U-förmige Gestalt oder eine J-förmige Gestalt aufweist, so daß, wenn der Elektrodenabschnitt gegen das Spitzende gedrückt wird, ein Teil der Oberfläche des Elektrodenabschnitts mit dem Spitzende abgeschabt wird,
wodurch selbst wenn der Tester einer übertriebenen Einwirkung ausgesetzt wird, sich der Tester nicht zurückziehen würde.

2. Verbindungsvorrichtung nach Anspruch 1, bei der die Aussparung zur Grundplatte und zum Nadelpresser hin geöffnet wird.

3. Verbindungsvorrichtung nach Anspruch 2, bei der der Nadelpresser (24, 152, 182) an den innenseitigen Abschnitten von wenigstens dem Grundabschnitt (31, 76, 146, 194, 208) der Tester anschlägt.

4. Verbindungsvorrichtung nach Anspruch 3, bei der der Nadelpresser (24, 182) eine zylindrische Gestalt aufweist und wenigstens in seiner Umfangsfläche elektrisch isolierend ausgebildet ist.

5. Verbindungsvorrichtung nach Anspruch 3, bei welcher der Nadelpresser (24) einen zylindrischen Presserstab (34) aufweist, sowie eine elastische Materialschicht (36), die aus einem elektrisch isolierenden Material um den Presserstab herum ausgebildet ist.

6. Verbindungsvorrichtung nach Anspruch 2, bei der die Aussparung (42, 84, 160, 188) eine bogenförmige oder rechteckige Querschnittsgestalt aufweist und wenigstens zur Grundplatte (20) hin geöffnet ist.

7. Verbindungsvorrichtung nach Anspruch 2, bei der die Abdeckung (26, 80, 150, 172, 204) ferner eine Öffnung (38) zur Aufnahme des Bauteils (12) aufweist.

8. Verbindungsvorrichtung nach Anspruch 2, bei welcher der Nadelpresser (90, 152, 182) ferner den Testerrückabschnitt des Testers gegen einen Teil der Innenfläche drückt, welche die Aussparung (84, 160, 188) definiert.

9. Verbindungsvorrichtung nach Anspruch 7, bei der jeder Tester (22, 50, 52, 54, 60, 72, 102, 112, 122, 132, 142, 190, 202) so ausgelegt ist, daß seine Nagelspitze in die Öffnung (38) hineinragt.

10. Verbindungsvorrichtung nach Anspruch 1, bei der die Testerrückabschnitte (114, 134) von zwei oder mehreren Testern (112, 132) einstückig aus einem elektrisch nicht leitfähigen Material ausgebildet sind, und wobei die Tester (112, 132) an ihren Grundabschnitten mit dem leitfähigen Abschnitt (28) in Kontakt gebracht werden.

11. Verbindungsvorrichtung nach Anspruch 1, bei welcher der außenseitige Abschnitt des Testers (22, 50, 52, 54, 60, 72, 102, 112, 122, 132, 142, 190, 202) sich in einer bogenförmigen Gestalt erstreckt, so daß er mit dem leitfähigen Abschnitt (28) in Kontakt kommt, wenn wenigstens der Elektrodenabschnitt (16) gegen das Spitzende gedrückt wird.

12. Verbindungsvorrichtung nach Anspruch 11, bei der der Tester elastisch deformierbar ist, so daß, je größer eine Preßkraft des zu testenden Bauteils (12) wird, desto mehr der Abschnitt des mit den mehreren leitfähigen Abschnitten (28) in Kontakt stehenden Außenbereichs sich in Richtung des Spitzendes bewegt.

13. Verbindungsvorrichtung nach Anspruch 1, bei der jeder Einschub (40, 82, 158, 186) zur Grundplatte (20) hin und in Richtung des zu testenden Bauteils (12) hin geöffnet wird und mit der Aussparung (42, 84, 160, 188) zusammenwirkt.

14. Verbindungsvorrichtung nach Anspruch 1, bei welcher der Rückzugsverhinderungsabschnitt einen Teil der Innenfläche umfaßt, welche die Aussparung definiert.

15. Verbindungsvorrichtung nach Anspruch 1, bei der jeder Tester in dem Einschub an einem Teil des deformierten Abschnitts (31, 76) in dem Einschub aufgenommen wird.

16. Verbindungsvorrichtung nach Anspruch 15, bei welcher der Rückzugsverhinderungsabschnitt einen Teil der Innenfläche umfaßt, welche die Aussparung (42, 84, 160, 188) definiert, oder der Endfläche, die einen Teil des Einschubes (40, 82) definiert.

17. Verbindungsvorrichtung nach Anspruch 1, bei welcher der Rückzugsverhinderungsabschnitt mit einem Stopper (56) versehen ist, der in der Abdeckung (26) angeordnet ist.

18. Verbindungsvorrichtung nach Anspruch 1, bei welcher der Tester (22, 50, 52, 54, 60, 72, 102, 112, 122, 132, 142, 190, 202) eine hintere Endfläche aufweist, die mit dem Rückzugsverhinderungsabschnitt in Kontakt steht.

## Revendications

1. Appareil de connexion pour connecter électriquement une pluralité de portions d'électrode (16) d'un dispositif (12) devant être testé, et une pluralité de portions conductrices (28) formées sur une face d'une plaque de base (20) lorsque le dispositif (12) devant être testé est poussé vers ladite plaque de base (20), par un poussoir (48), ledit appareil de connexion comprenant :
- une pluralité de sondes (22, 50, 52, 54, 60, 72, 102, 112, 122, 132, 142, 190, 202) ; et
- un équipement d'assemblage (24, 26, 80, 90, 150, 152, 154, 172, 182, 204) pour assembler lesdites sondes de façon parallèle à ladite plaque de base, de manière telle que lesdites sondes soient disposées suivant des intervalles dans une direction,
dans lequel chaque sonde (22, 50, 52, 54, 60, 72, 102, 112, 122, 132, 142, 190, 202) comprend une portion de base de la sonde (31, 76, 146, 194, 208) qui est incurvée, de façon à avoir une portion intérieure et une portion extérieure devant venir en contact avec la pluralité des portions conductrices, une portion avant de la sonde (30, 74, 144, 192, 206) formant un ensemble continu avec une extrémité de ladite portion de base de la sonde, et une portion arrière de la sonde (32, 78, 104, 114, 124, 134, 148, 196, 210) formant un ensemble continu avec l'autre extrémité de ladite portion de base de la sonde,
dans lequel ledit équipement d'assemblage (24, 26, 80, 90, 150, 152, 154, 172, 182, 204) est doté d'au moins un couvercle devant être assemblé avec ladite plaque de base (20), ledit couvercle ayant une cavité (42, 84, 160, 188) s'étendant dans ladite direction précitée et ayant une pluralité de fentes à des intervalles placés dans ladite direction précitée,
- et un poussoir à aiguille (24, 90, 152, 182) logé dans la cavité (42, 84, 160, 188), servant à pousser lesdites sondes, de façon à placer au moins une partie desdites portions de base ou desdites portions arrière desdites sondes en contact avec les portions conductrices (28) de ladite plaque de base (20) et s'étendant dans ladite direction précitée,
**caractérisé**
**en ce que** ladite portion avant de la sonde (30, 74, 144, 192, 206) a une extrémité de la pointe pour pousser contre ladite portion d'électrode lorsque ledit dispositif (12) devant être testé est poussé vers ladite plaque de base (20), dans lequel chaque sonde est prévue pour pénétrer dans ladite fente (40, 82, 158, 186) et faire en sorte que l'extrémité de sa pointe dépasse de ladite fente (40, 82, 158, 186),
**en ce que** ledit équipement d'assemblage (24, 26, 80, 90, 150, 152, 154, 172, 182, 204) est doté en outre d'une portion anti-rétraction (40a, 56, 84a, 160a, 188a) pour empêcher lesdites sondes de se rétracter lorsque ladite portion d'électrode est poussée contre la pointe, et
chaque sonde a la portion arrière placée en contact avec ladite portion anti-rétraction (40a, 56, 84a, 160a, 188a), et
a une forme en arc, une forme en U ou une forme en J, de façon à enlever en grattant, avec l'extrémité de la pointe, une partie de la surface de ladite portion d'électrode lorsque ladite portion d'électrode est poussée contre ladite extrémité de la pointe,
faisant que, même si la sonde est soumise à une action de surcharge, la sonde ne doit pas se rétracter.

2. Appareil de connexion selon la revendication 1, dans lequel ladite cavité est ouverte vers ladite plaque de base et vers ledit poussoir à aiguille.

3. Appareil de connexion selon la revendication 2, dans lequel ledit poussoir à aiguille (24, 152, 182) vient en butée contre lesdites portions intérieures d'au moins ladite portion de base (31, 76, 146, 194, 208) desdites sondes.

4. Appareil de connexion selon la revendication 3, dans lequel ledit poussoir à aiguille (24, 182) a une forme cylindrique et est fabriqué en étant électriquement isolé, au moins dans sa surface périphérique.

5. Appareil de connexion selon la revendication 3, dans lequel ledit poussoir à aiguille (24) comprend une barre de poussoir cylindrique (34) et une couche d'un matériau élastique (36) composée d'un matériau d'isolation électrique autour de ladite barre du poussoir.

6. Appareil de connexion selon la revendication 2, dans lequel ladite cavité (42, 84, 160, 188) a, en section, une forme en arc ou une forme rectangulaire et s'ouvre au moins vers ladite plaque de base (20).

7. Appareil de connexion selon la revendication 2, dans lequel ledit couvercle (26, 80, 150, 172, 204) comprend en outre une ouverture (38) pour loger ledit dispositif (12).

8. Appareil de connexion selon la revendication 2, dans lequel ledit poussoir à aiguille (90, 152, 182) pousse en outre la portion arrière de ladite sonde contre une partie de la surface intérieure définissant ladite cavité (84, 160, 188).

9. Appareil de connexion selon la revendication 7, dans lequel chaque sonde (22, 50, 52, 54, 60, 72, 102, 112, 122, 132, 142, 190, 202) a sa pointe d'aiguille qui dépasse dans ladite ouverture (38).

10. Appareil de connexion selon la revendication 1, dans lequel les portions arrière (114, 134) de deux sondes ou plus (112, 132) sont intégralement constituées d'un matériau non électroconducteur, et dans lequel lesdites sondes (112, 132) sont placées en contact avec ladite portion conductrice (28) au niveau de leurs portions de base.

11. Appareil de connexion selon la revendication 1, dans lequel ladite portion extérieure de ladite sonde (22, 50, 52, 54, 60, 72, 102, 112, 122, 132, 142, 190, 202) s'étend dans une forme en arc, de façon à venir en contact avec ladite portion conductrice (28) quand au moins ladite portion d'électrode (16) est poussée contre l'extrémité de la pointe.

12. Appareil de connexion selon la revendication 11, dans lequel ladite sonde est élastiquement déformable, de manière telle que plus la force de poussée, par ledit dispositif (12) devant être testé, augmente, plus la portion de ladite zone extérieure, en contact avec ladite pluralité de portions conductrices (28), se déplace vers ladite extrémité de la pointe.

13. Appareil de connexion selon la revendication 1, dans lequel chaque fente (40, 82, 158, 186) est ouverte vers ladite plaque de base (20) et vers le dispositif (12) devant être testé, et communique avec la cavité (42, 84, 160, 188).

14. Appareil de connexion selon la revendication 1, dans lequel ladite portion anti-rétraction comprend une partie de la surface intérieure définissant ladite cavité.

15. Appareil de connexion selon la revendication 1, dans lequel chaque sonde est logée dans ladite fente, au niveau d'une partie de ladite portion déformée (31, 76).

16. Appareil de connexion selon la revendication 15, dans lequel ladite portion anti-rétraction comprend une partie de la surface intérieure définissant ladite cavité (42, 84, 160, 188) ou la surface d'extrémité définissant une partie de ladite fente (40, 82).

17. Appareil de connexion selon la revendication 1, dans lequel ladite portion anti-rétraction est dotée d'une butée (56) disposée dans ledit couvercle (26).

18. Appareil de connexion selon la revendication 1, dans lequel ladite sonde (22, 50, 52, 54, 60, 72, 102, 112, 122, 132, 142, 190, 202) comprend une face d'extrémité arrière en contact avec ladite portion anti-rétraction.
